# EUROPEAN PATENT APPLICATION

(11) **EP 4 719 001 A1**
(43) Date of publication of application: **01.04.2026**
(21) Application number: 25204545.5
(22) Date of filing: 25.09.2025
(51) Int. Cl.: H10F 30/223, G01S 7/481, H10F 55/255, H10F 77/124, H10F 77/20, H10F 77/30, H10F 77/40, H10F 77/50, H10H 20/80

(54) **LIGHT DETECTING DEVICE**

(30) Priority: 27.09.2024 US 202418900223
(71) Applicant: Epistar Corporation, Hsinchu 300 (TW)
(72) Inventor: CHEN, Wei-Long, 300 Hsinchu (TW); CHEN, I-Hung, 300 Hsinchu (TW); TSAI, Chang-Da, 300 Hsinchu (TW); HUANG, Chao-Shun, 300 Hsinchu (TW); SU, Chu-Jih, 300 Hsinchu (TW); YEN, Shao-Lung, 300 Hsinchu (TW)
(74) Representative: Ter Meer Steinmeister & Partner

(57) **Abstract**

A light detecting device includes a first semiconductor layer, an absorption layer located on the first semiconductor layer, a second semiconductor layer located on the absorption layer, a filter structure located on the second semiconductor layer, an opening formed in the filter structure, and an electrode structure disposed on the filter structure. The electrode structure connects the second semiconductor layer through the opening. The filter structure includes a plurality of first layers and a plurality of second layers which are alternately stacked. The plurality of the first layers includes an uppermost first layer with a first refractive index, and one of the plurality of second layers has a second refractive index larger than the first refractive index. The uppermost first layer is located between the electrode structure and the plurality of second layers and directly contacts the electrode structure.

## Description

### Technical Field

The present disclosure relates to a light detecting device, and particularly to an infrared light detecting device with low responsivity for visible light.

### Description of Background Art

An optoelectronic semiconductor device mainly involves the conversion between light and electricity. A light emitting device, such as a light-emitting diode (LED) or a laser diode (LD), can convert electricity to light, and a photovoltaic cell (PVC) or a light detecting device, such as photodiode (PD), can convert light to electricity. LEDs have been widely applied to illumination and light sources of various electronic devices, and LDs have also been applied to projectors and proximity sensors extensively. PVCs can be applied to power plants and power generation centers for use in space, and PDs can be applied to fields of night vision, ranging, biosensing and communication. As related applications of the light detecting device are gradually developed, the application scenarios thereof are becoming more and more complex, and the requirements for reducing noise are getting more and more stringent.

### Summary of the Disclosure

The present disclosure provides a light detecting device.

The light detecting device includes a first semiconductor layer, an absorption layer located on the first semiconductor layer, a second semiconductor layer located on the absorption layer, a filter structure disposed on the second semiconductor layer, an opening formed in the filter structure, and an electrode structure disposed on the filter structure. The electrode structure connects the second semiconductor layer through the opening. The filter structure includes a plurality of first layers and a plurality of second layers which are alternately stacked, and the plurality of the first layers includes an uppermost first layer with a first refractive index and one of the plurality of second layers has a second refractive index larger than the first refractive index. The uppermost first layer is located between the electrode structure and the plurality of second layers and directly contacts the electrode structure.

The present disclosure further provides a light detecting module. The light detecting module includes a light emitting device, the light detecting device, a carrier electrically connecting to the light emitting device and the light detecting device, and an encapsulation structure covering the light emitting device and the light detecting device.

In one or more embodiments, the second semiconductor layer may have a third refractive index larger than the first refractive index.

In one or more embodiments, the second semiconductor layer may have a third refractive index equal to or smaller than the second refractive index.

In one or more embodiments, the plurality of first layers may comprise a lowermost first layer.

In one or more embodiments, the plurality of second layers may be located between the lowermost first layer and the uppermost first layer.

In one or more embodiments, a sum of thicknesses of the plurality of first layers may be larger than a sum of thicknesses of the plurality of second layers.

In one or more embodiments, the light detecting device may comprise a contact structure located between the second semiconductor layer and the electrode structure without contacting the filter structure.

In one or more embodiments, the contact structure may be disposed in the opening.

In one or more embodiments, the electrode structure may comprise a pad portion disposed on the uppermost first layer and an extending portion connecting the pad portion and the second semiconductor layer.

In one or more embodiments, the second semiconductor layer may comprise a first doping region and a second doping region surrounding the first doping region.

In one or more embodiments, the pad portion may not overlap with the first doping region in a vertical direction.

In one or more embodiments, the opening may overlap with the first doping region in the vertical direction.

In one or more embodiments, the extending portion may connect the first doping region through the opening.

In one or more embodiments, the light detecting device may comprise a passivation layer located between the filter structure and the second semiconductor layer.

In one or more embodiments, the light detecting device may comprise a conductive layer disposed on the passivation layer without contacting the second semiconductor layer.

In one or more embodiments, the second semiconductor layer may have a thickness larger than that of the filter structure.

In one or more embodiments, the absorption layer may have a first width.

In one or more embodiments, the filter structure may have a second width equal to the first width.

In another aspect a light detecting module is provided, comprising: a carrier; a light emitting device located on the carrier and emitting a light; a light detecting device as described in any one of the embodiments described above located on the carrier and detecting the light; and an encapsulation structure covering the light emitting device and the light detecting device.

### Brief Description of the Drawings

FIG.1 is a schematic top view of a light detecting device of some embodiments of the disclosure;
FIG. 2 shows a schematic sectional view of the light detecting device along a section line A-A' shown in FIG. 1;
FIG. 3 shows an enlarged view of region B of the light detecting device shown in FIG. 2;
FIG. 4 shows a schematic sectional view of a light detecting device according to some other embodiments of the present disclosure;
FIG. 5 shows a schematic top view of a light detecting device according to some other embodiments of the present disclosure;
FIG. 6 is a schematic sectional view of a light detecting device along a section line A-A' in FIG.5;
FIG. 7 shows a schematic sectional view of a light detecting device according to still other embodiments of the present disclosure;
FIG. 8 shows a schematic sectional view of a light detecting module according to some embodiments of the present disclosure.

### Detailed Description of Preferred Embodiments

The following embodiments will be described with accompany drawings to disclose the concept of the present disclosure. In the drawings or description, same or similar portions are indicated with same or similar numerals. Furthermore, a shape or a size of a member in the drawings may be enlarged or reduced. Particularly, it should be noted that a member which is not illustrated or described in drawings or description may be in a form that is known by a person skilled in the art.

A person skilled in the art can realize that addition of other components based on a structure recited in the following embodiments is allowable. For example, if not otherwise specified, a description similar to "a first layer/structure is on or under a second layer/structure" may include an embodiment in which the first layer/structure directly (or physically) contacts the second layer/structure, and may also include an embodiment in which another structure is provided between the first layer/structure and the second layer/structure, such that the first layer/structure and the second layer/structure do not physically contact each other. In addition, it should be realized that a positional relationship of a layer/structure may be altered when being observed in different orientations.

In the present disclosure, if not otherwise specified, the general formula InGaP represents Inₓ₀Ga₁₋ₓ₀P, wherein 0<x0<1; the general formula AlInP represents Alₓ₁In₁₋ₓ₁P, wherein 0<x1<1; the general formula AlGaInP represents Alₓ₂Gaₓ₃In₁₋ₓ₂₋ₓ₃P, wherein 0<x2<1 and 0<x3<1; the general formula InGaAsP represents Inₓ₄Ga₁₋ₓ₄Asₓ₅P₁₋ₓ₅, wherein 0<x4<1 , 0<x5<1; the general formula AlGaInAs represents Alₓ₆Gaₓ₇In₁₋ₓ₆₋ₓ₇As, wherein 0<x6<1 and 0<x7<1; the general formula InGaAsN represents Inₓ₈Ga₁₋ₓ₈Asₓ₉N₁₋ₓ₉, wherein 0<x8<1 and 0<x9<1; the general formula InGaAs represents Inₓ₁₀Ga₁₋ₓ₁₀As, wherein 0<x10<1; the general formula AlGaAs represents Alₓ₁₁Ga₁₋ₓ₁₁As, wherein 0<x11<1. The content of each element may be adjusted for different purposes, for example, for adjusting the band gap, or the cut-off wavelength of a light detecting device. However, the present disclosure is not limited thereto.

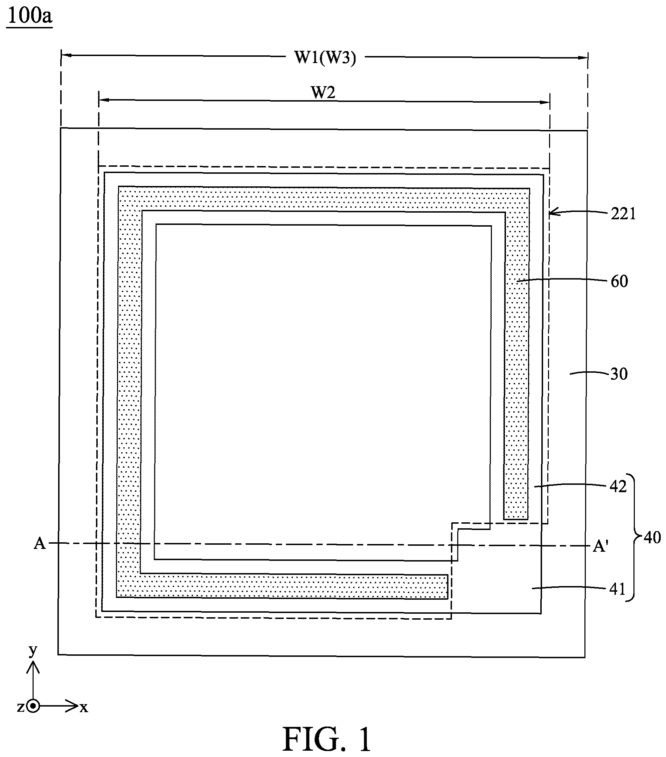

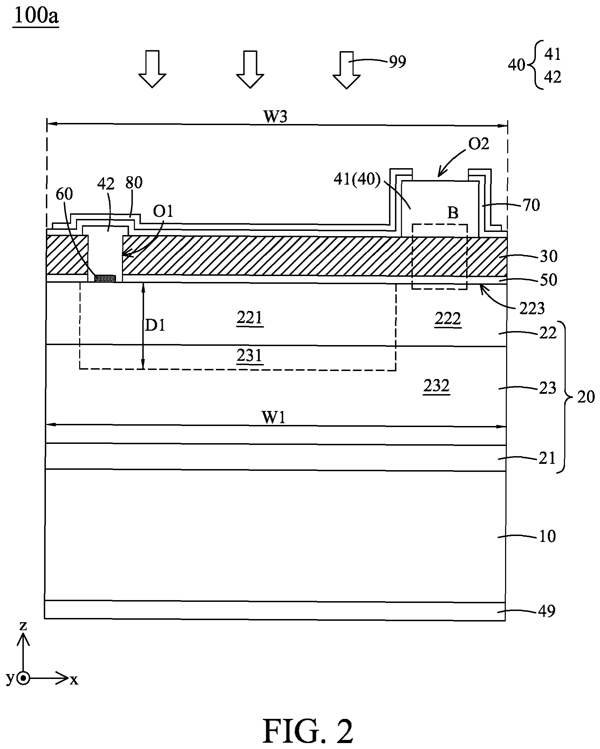

Refer to FIG. 1 and FIG. 2, FIG. 1 shows a schematic top perspective view of the light detecting device 100a according to some embodiments of the present disclosure, and FIG. 2 shows a schematic sectional view of the light detecting device 100a along a section line A-A' shown in FIG. 1. As shown in FIGS. 1-2, the light detecting device 100a includes a semiconductor stack 20, a filter structure 30 disposed on the semiconductor stack 20, a first electrode structure 40 disposed on the filter structure 30 and a second electrode structure 49 disposed below the semiconductor stack 20. The first electrode structure 40 and the second electrode structure 49 are located at two opposite sides of the semiconductor stack 20 to form a vertical type light detecting device. As shown in FIG. 2, the light detecting device 100a can absorb an incident light 99 and convert the incident light 99 into an electrical signal.

In some embodiments, the light detecting device 100a optionally includes a base 10 located between the semiconductor stack 20 and the second electrode structure 49. The base 10 may be a temporary substrate or a permanent substrate and may be transparent to the incident light 99. In some embodiments, in a vertical direction (corresponding to Z-axis), the base 10 has a thickness in a range of 100 µm to 200 µm to provide sufficient mechanical strength for the light detecting device 100a.

The semiconductor stack 20 includes a first semiconductor layer 21, a second semiconductor layer 22 and an absorption layer 23 located between the first semiconductor layer 21 and the second semiconductor layer 22. The first semiconductor layer 21 is located between the base 10 and the second semiconductor layer 22, and the first electrode structure 40 is disposed on the second semiconductor layer 22. In some embodiments, the second semiconductor layer 22 includes a first doping region 221 and a second doping region 222 surrounding the first doping region 221.

In some embodiments, the base 10, the first semiconductor layer 21, the second semiconductor layer 22 and/or the absorption layer 23 may be a III-V compound semiconductor material, and may be a binary III-V semiconductor, a ternary III-V semiconductor or a quaternary III-V semiconductor, such as AlGaInAs, AlGaInP, AlInGaN, AlAsSb, InGaAsP, InGaAsN, AlGaAsP, GaAs, InGaAs, AlGaAs, AlInAs, GaAsP, GaP, InGaP, AlInP, GaN, InP, InGaN or AlGaN. The first semiconductor layer 21 and the second semiconductor layer 22 include the same or different materials. In some embodiments, the first semiconductor layer 21, the second semiconductor layer 22 and/or the absorption layer 23 can be lattice-matched to each other. It should be noticed that the term "lattice-matched" refers to a ratio of the difference between the lattice constants of two adjacent layers to the average of the lattice constants of two adjacent layers is smaller than or equal to 0.1%.

In some embodiments, the first semiconductor layer 21 and the second doping region 222 have a first conductivity type, and the first doping region 221 of the second semiconductor layer 22 has a second conductivity type different from the first conductivity type. For example, the first conductivity type and the second conductivity type may be n-type and p-type, or p-type and n-type, respectively. Specifically, the first semiconductor layer 21 includes a first dopant to have the first conductivity type, the first doping region 221 of the second semiconductor layer 22 includes a second dopant and a third dopant, and the second doping region 222 of the second semiconductor layer 22 only includes the third dopant. In some embodiments, the second dopant and the third dopant cause the second semiconductor layer 22 to have both the second conductivity type and the first conductivity type. Since the second dopant has a doping concentration higher than that of the third dopant, the first doping region 221 has the second conductivity type, and the second doping region 222 has the first conductivity type. The second dopant is different from the first dopant and the third dopant, and the third dopant and the first dopant may be the same or different. In some embodiments, the first dopant, the second dopant and the third dopant can respectively be zinc (Zn), beryllium (Be), magnesium (Mg), carbon (C), silicon (Si), germanium (Ge), tin (Sn), sulfur (S), selenium (Se), or tellurium (Te).

The absorption layer 23 may be undoped or unintentionally doped, and the first doping region 221, the absorption layer 23 and the first semiconductor layer 21 form a p-i-n structure in the light detecting device 100a. It should be noticed that the term "unintentional doped" refers to a situation that a dopant naturally diffuses into the absorption layer 23. For example, the absorption layer 23 may include the first dopant from the first semiconductor layer 21 and/or the third dopant from the second semiconductor layer 22. When the absorption layer 23 is unintentional doped, the sum of the doping concentrations of the first dopant and the third dopant in the absorption layer 23 is less than 10¹⁶/cm³.

As shown in FIG. 2, in some embodiments, the absorption layer 23 may optionally include a third doping region 231 corresponding to the first doping region 221 of the second semiconductor layer 22. The third doping region 231 connects to the first doping region 221 and includes the second dopant to have the second conductivity type. As such, the other region of the absorption layer 23 without the second dopant may be defined as an undoped region 232, and the third doping region 231 is surrounded by the undoped region 232. In some embodiments, as the third doping region 231 has the first dopant, the second dopant and the third dopant, the second dopant has a doping concentration higher than those of the third dopant and the first dopant so the third doping region 231 has the second conductivity type. In a horizontal direction (corresponding to X-axis), the undoped region 232 of the absorption layer 23 has a first width W1, and the first doping region 221 (and/or the third doping region 231) has a second width W2 smaller than the first width W1.

In some embodiments, the first doping region 221 and the third doping region 231 may be formed by adding the second dopant into the second semiconductor layer 22 and the absorption layer 23 through a diffusion process or an ion implantation process. In the vertical direction (corresponding to Z-axis), the second dopant may have a diffusion depth D1 which is corresponding to a sum of a thickness of the first doping region 221 and a thickness of the third doping region 231. The capacitance and response time of the light detecting device 100a can be changed by adjusting the diffusion depth D1.

In some embodiments, the first dopant in the first semiconductor layer 21 may have a doping concentration in a range between 10¹⁷ and 5x10¹⁸/cm³, the second dopant in the first doping region 221 and/or the third doping region 231 may have a doping concentration in a range between 2x10¹⁷ and 5x10¹⁹/cm³, and the third dopant in the first doping region 221 and the second doping region 222 may have a doping concentration in a range between 10¹⁷ and 5x10¹⁸/cm³. In some embodiments, the doping concentration of the first dopant may have a gradient change. For example, the doping concentration of the first dopant in the first semiconductor layer 21 may be gradually increased or decreased along the vertical direction (corresponding to Z-axis)..

As shown in FIG. 2, in some embodiments, the second semiconductor layer 22 has a first surface 223 away from the absorption layer 23. When the light detecting device 100a is in operation, the incident light 99 enters the semiconductor stack 20 through the first surface 223 and is absorbed by the absorption layer 23 to generate electrons and holes. Through applying an external bias, the electrons and holes, or holes and electrons, move to the first electrode structure 40 and the second electrode structure 49 respectively, so that the light detecting device 100a can output the electrical signal, such as a photocurrent.

The absorption layer 23 has a first band gap and a first cut-off wavelength, and the absorption layer 23 can absorb the light with a wavelength equal to or smaller than the first cut-off wavelength. In some embodiments, the absorption layer 23 include materials with an band gap of 3.1ev to absorb light with a wavelength below 400 nm (such as ultraviolet light); or materials with an band gap of 2.14ev to absorb light with a wavelength below 580 nm (such as green light, blue light or ultraviolet light); or materials with an band gap of 0.77ev to absorb light with wavelengths below 1600 nm (such as infrared light, red light, green light, blue light or ultraviolet light).

In some embodiments, the light detecting device 100a may be designed to detect the light within a target wavelength range, and the target wavelength range of the light detecting device 100a may be determined by the band gaps of the absorption layer 23 and the second semiconductor layer 22. Specifically, the second semiconductor layer 22 has a second band gap and a second cut-off wavelength, and the second semiconductor layer 22 can absorb the light with a wavelength equal to or smaller than the second cut-off wavelength. Since the second band gap is larger than the first band gap, the second cut-off wavelength is smaller than the first cut-off wavelength. In some embodiments, the incident light 99 includes a first portion with a wavelength equal to or smaller than the second cut-off wavelength and a second portion with a wavelength larger than the second cut-off wavelength and equal to or smaller than first cut-off wavelength. As the incident light 99 enters the semiconductor stack 20 through the first surface 223, the first portion can be absorbed by the second semiconductor layer 22, and the second portion can pass the second semiconductor layer 22 and be absorbed by the absorption layer 23. Thus, the electrical signal generated by the absorption layer 23 substantially corresponds to the second portion, and the target wavelength range may be regarded as the range between the first cut-off wavelength and the second cut-off wavelength.

For example, when the light detecting device 100a is an infrared detector, the absorption layer 23 may be designed to have a material with a band gap of 0.77 eV (such as InGaAs) to absorb the light with a wavelength equal to or smaller than 1600 nm. The second semiconductor layer 22 may be designed to have a material with a band gap of 1.37 eV (such as InP) to absorb the light with a wavelength equal to or smaller than 900 nm (corresponding to the first portion). Thus, the light detecting device 100a has the target wavelength range from 900 nm to 1600 nm (corresponding to the second portion).

In some embodiments, the first portion (the light outside the target wavelength range) of the incident light 99 may not be completely absorbed by the second semiconductor layer 22 and enter the absorption layer 23, and the electrical signal caused by absorbing the first portion by the absorption layer 23 is regarded as noise. As mentioned in the example of the previous paragraph, the first portion may be the light with a wavelength below 900 nm.

In the vertical direction (corresponding to Z-axis), the absorption layer 23 has a thickness larger than that of the first semiconductor layer 21 and/or that of the second semiconductor layer 22, and the thickness of the second semiconductor layer 22 may be equal to or larger than the thickness of the first semiconductor layer 21. In some embodiments, the thickness of the first semiconductor layer 21 may be equal to or smaller than 1 µm to shorten transmission length of electrons or holes, the thickness of the second semiconductor layer 22 may be equal to or larger than 0.5 µm and smaller than 2 µm to enhance absorption of the light outside the target wavelength range and reduce the noise, and the thickness of the absorption layer 23 may be between 1 µm and 4 µm to enhance light absorption and improve strength of the electrical signal. In some embodiments, the diffusion depth D1 may be larger than, equal to or smaller than the thickness of the second semiconductor layer 22, and a difference between the diffusion depth D1 and the thickness of the second semiconductor layer 22 may be in a range of 0.1 µm to 0.3 µm for reducing dark current.

As shown in FIG. 2, the filter structure 30 is disposed on the first surface 223 of the second semiconductor layer 22 and covers the first doping region 221 and the second doping region 222. The filter structure 30 can further reduce the light outside the target wavelength range to enter the semiconductor stack 20, so as to further lower the noise and improve a signal-noise ratio (SNR) of the light detecting device 100a. Specifically, the filter structure 30 may be designed to have a stop band with low transmittance for the light outside the target wavelength range, such as the first portion of the incident light 99. In some embodiments, the stop band refers to a region of the spectrum with a wavelength equal to or smaller than the second cut-off wavelength. Since the incident light 99 passes through the filter structure 30 and the second semiconductor layer 22 in sequence before entering the absorption layer 23, the first portion (the light outside the target wavelength range) will be firstly filtered out by the filter structure 30 and then absorbed by the second semiconductor layer 22. Thus, through disposing the filter structure 30, the amount of the first portion entering the absorption layer 23 can be further reduced, thereby decreasing the noise caused by the first portion.

For example, when the light detecting device 100a has the target wavelength range of 900 nm to 1600 nm for detecting the infrared light, the filter structure 30 may be designed to have the stop band from 400 nm to 800 nm for reducing the noise caused by the visible light. In some embodiments, the filter structure 30 may have an average transmittance smaller than 5 % for the light with a wavelength between 400 nm to 800 nm, such as 4%, 3%, 2% or 1 %. In some embodiments, the light detecting device 100a with the filter structure 30 has a responsivity equal to or smaller than 2 mA/W for the light with a wavelength between 400 nm to 800 nm.

As shown in FIG.2, in the horizontal direction (corresponding to X-axis), the filter structure 30 has a third width W3 which may be equal to or smaller than the first width W1. In the vertical direction, the filter structure 30 has a thickness which may be larger than, equal to or smaller than the thickness of the second semiconductor layer 22. In some embodiments, the filter structure 30 has a thickness between 0.4 µm and 4 µm to meet the thinning requirement of the light detecting device 100a.

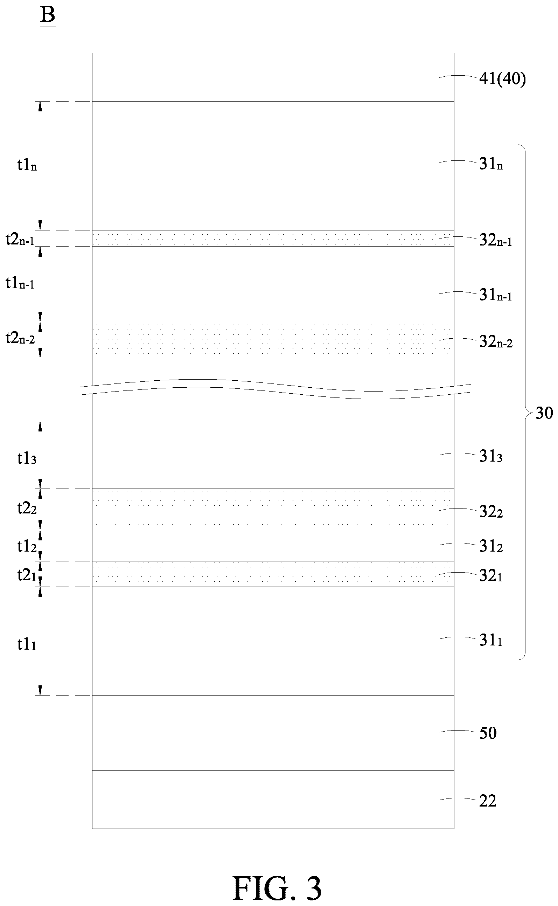

Refer to FIG. 3, FIG. 3 shows an enlarged view of region B of the light detecting device 100a shown in FIG.2. The filter structure 30 includes a plurality of first layers 31 and a plurality of second layers 32, and the plurality of first layers 31 and the plurality of second layers 32 are alternately stacked with each other along the vertical direction (corresponding to Z-axis). In some embodiments, the number of the plurality of first layers 31 may be equal to or larger than the plurality of second layers 32. As shown in FIG. 3, the number of the plurality of first layers 31 is n and the number of the plurality of second layers 32 is n-1. That is, the filter structure 30 includes a first layer 31₁, a second layer 32₁, a first layer 31₂, a second layer 32₂, ..., a first layer 31ₙ₋₁, a second layer 32ₙ₋₁ and a first layer 31ₙ that are stacked in sequence along the vertical direction. The first layer 31₁ and the first layer 31ₙ are defined as the lowermost first layer and the uppermost first layer respectively, while the second layer 32₁ and the second layer 32ₙ₋₁ are defined as the lowermost second layer and the uppermost second layer respectively. In some embodiments, the number n may be in a range of 5 to 20. In some embodiments, the lowermost first layer 31₁ is located between the lowermost second layer 32₁ and the second semiconductor layer 22 and separates the lowermost second layer 32₁ from the second semiconductor layer 22. In some embodiments, the uppermost first layer 31ₙ is located between the uppermost second layer 32ₙ₋₁ and the first electrode structure 40 and separates the uppermost second layer 32ₙ₋₁ from the first electrode structure 40. That is, the plurality of second layers 32 is located between the lowermost first layer 31₁ and the uppermost first layer 31ₙ. In some embodiments, the lowermost first layer 31₁ may directly connect to the second semiconductor layer 22, and/or the uppermost first layer 31ₙ may directly contact the first electrode structure 40.

Each first layer 31 has a first refractive index (n1ᵢ, wherein i=1, 2...n), and each second layer 32 has a second refractive index (n2ᵢ, wherein i=1, 2...n-1) larger than the first refractive index. In some embodiments, the first refractive indexs of the plurality of first layers 31 may be the same or different, and the second refractive indexs of the plurality of second layers 32 may be the same or different. In some embodiments, the first refractive index in each first layer 31 is equal to or smaller than 1.7, such as 1.6, 1.4 or 1.2. In some embodiments, the second refractive index in each second layer 32 is equal to or larger than 2, such as 2.4, 2.8, 3.2 or 3.6. In some embodiments, a difference between the first refractive index and the second refractive index may be equal to or larger than 0.3. In some embodiments, the second semiconductor layer 22 has a third refractive index, and the third refractive index is larger than the first refractive index of the first layer 31. In some embodiments, the third refractive index is equal to or smaller than the second refractive index of the second layer 32.

As shown in FIG. 3, in the vertical direction (corresponding to Z-axis), each first layer 31 has a first thickness (t1ᵢ, wherein i=1, 2...n), and each second layer 32 has a second thickness (t2ᵢ, wherein i=1, 2...n-1). For example, the first layer 31₁ has a first thickness t1₁, the first layer 31₂ has a first thickness t1₂...and the first layer 31ₙ has a first thickness t1ₙ. Similarly, the second layer 31₁ has a second thickness t2₁, the second layer 32₂ has a second thickness t2₂...and the second layer 32ₙ₋₁ has a second thickness t2ₙ₋₁. In some embodiments, the first thicknesses of the plurality of first layers 31 may be the same or different, and/or the second thicknesses of the plurality of second layers 32 may be the same or different.

In some embodiments, a sum of the first thicknesses (including t1₁, t1₂...t1ₙ) of the plurality of first layer 31 is larger than a sum of the second thicknesses (including t2₁, t2₂...t2ₙ₋₁) of the plurality of second layer 32. In some embodiments, the first thickness t1₁ of the first layer 31₁ (the lowermost first layer) and the first thickness t1ₙ of the first layer 31ₙ (the uppermost first layer) are larger than the first thicknesses t1₂, t1₃...t1ₙ₋₁ of the other first layers 31₂, 31₃...31ₙ₋₁. In some embodiments, the second thickness t2ₙ₋₁ of the second layer 32ₙ₋₁ (the uppermost second layer) is smaller than the second thicknesses t2₁, t2₂...t2ₙ₋₂ of the other second layers 32₁, 32₂...32ₙ₋₂. In some embodiments, the second thickness (t2₁, t2₂ ..., or t2ₙ₋₁) of each second layer 32 is smaller than 100 nm.

In some embodiments, the plurality of first layers 31 of the filter structure 30 may be a dielectric layer, and may include an oxide, a nitride or a fluoride, such as silicon oxide (SiOx), aluminum oxide (AlOx), silicon nitride (SiNx), magnesium fluoride (MgFx), or a combination thereof. In some embodiments, the plurality of second layers 32 of the filter structure 30 may include a semiconductor material, such as amorphous silicon (a-Si), amorphous germanium (aGe), amorphous silicon germanium (a-SiGe), InP, GaAs, or a combination thereof.

Refer to FIG. 2 again, the first electrode structure 40 is disposed on the filter structure 30 and electronically connects to the second semiconductor layer 22. Specifically, the filter structure 30 can be patterned to form a first opening O1 to expose the first doping region 221 of the second semiconductor layer 22. In some embodiments, the first electrode structure 40 includes a pad portion 41 and an extending portion 42 connecting with the pad portion 41 and the second semiconductor layer 22. In some embodiments, the pad portion 41 is located on the filter structure 30 without contacting the second semiconductor layer 22. In some embodiments, the extending portion 42 is patterned and disposed in the first opening O1 to connects the first doping region 221, so that the pad portion 41 forms an electrically connection with the first doping region 221.

As shown in FIG. 2, in the horizontal direction (corresponding to X-axis), the extending portion 42 has a width equal to or larger than that of the first opening O1. In some embodiments, the first opening O1 does not overlap with the second doping region 222 in the vertical direction (corresponding to Z-axis), so the extending portion 42 contacts the first doping region 221 without contacting the second doping region 222. In some embodiments, the pad portion 41 is disposed on the second doping region 222 and may not overlap with the first doping region 221 in the vertical direction to avoid reducing the sensitivity of the light detecting device 100a caused by blocking the incident light 99 entering the first doping region 221. In some embodiments, in the vertical direction, the first electrode structure 40 has a thickness larger than that of the thickness of the filter structure 30.

In some embodiments, the first electrode structure 40 and the second electrode structure 49 can have a single-layer or multi-layer structure and include metal materials, such as aluminum (Al), chromium (Cr), copper (Cu), tin (Sn), gold (Au), and nickel. (Ni), titanium (Ti), platinum (Pt), lead (Pb), zinc (Zn), cadmium (Cd), antimony (Sb), cobalt (Co), beryllium (Be), germanium (Ge) or alloys which include the aforementioned metal materials.

In some embodiments, the light detecting device 100a may optionally further include a passivation layer 50, a first contact structure 60, an anti-reflective layer 70 and/or a conductive layer 80. As shown in FIG. 2, the passivation layer 50 is disposed between the second semiconductor layer 22 and the filter structure 30 and covers the first doping region 221 and the second doping region 222 to reduce dark current of the light detecting device 100a. In some embodiments, the first opening O1 further extends into the passivation layer 50 for the extending portion 42 to connect the first doping region 221. Further refer to FIG. 3, the passivation layer 50 may directly contact the lowermost first layer 31₁ and the second semiconductor layer 22. In some embodiments, the passivation layer 50 has a fourth refractive index between the first refractive index of the first layer 31 and the third refractive index of the second semiconductor layer 22, to reduce reflection between the filter structure 30 and the second semiconductor layer 22.

In some embodiments, the first contact structure 60 is disposed between the first electrode structure 40 and the second semiconductor layer 22 to reduce the resistance formed therebetween. The first contact structure 60 can be patterned to corresponding to the extending portion 42 and/or the pad portion 41. As shown in FIG. 1 and FIG. 2, the first contact structure 60 is disposed on the first doping region 221 and located in the first opening O1 without contacting the filter structure 30. In some embodiments, the extending portion 42 contacts the first contact structure 60 and the first doping region 221. In the horizontal direction (corresponding to X-axis), the first contact structure 60 has a width equal to or smaller than that of the extend portion 42. In the vertical direction (corresponding to Z-axis), the first contact structure 60 may have a thickness in a range between 30 nm to 150 nm.

In some embodiments, the first contact structure 60 include a III-V compound semiconductor material, such as GaAs, GaP or InGaAs. In some embodiments, the first contact structure 60 has a fourth dopant and has a conductivity type same as that of the first doping region 221. In some embodiments, the fourth dopant has a doping concentration larger than that of the second dopant of the first doping region 221, and the fourth dopant may be the same or different from the second dopant.

Referring to FIG. 2 again, the anti-reflective layer 70 is disposed on the filter structure 30 and the first electrode structure 40 to reduce reflection of the incident light 99. In some embodiments, the anti-reflective layer 70 is between the filter structure 30 and the first electrode structure 40. In some embodiments, a second opening O2 is formed in the anti-reflective layer 70 to expose the pad portion 41 for connecting external power.

In some embodiments, the passivation layer 50 and the anti-reflection layer 70 include dielectric materials, such as tantalum oxide (TaOx), aluminum oxide (AlOx), silicon oxide (SiOx), titanium oxide (TiOx), silicon nitride (SiNx), silicon oxynitride (SiOxNy), niobium pentoxide (Nb₂Os) or spin-on glass (SOG).

In some embodiments, the conductive layer 80 is disposed on the second semiconductor layer 22 to protect the light detecting device 100a from being affected or damaged by electromagnetic interference (EMI). In addition, the conductive layer 80 does not contact the second semiconductor layer 22 to avoid forming undesired current path. As shown in FIG. 2, the conductive layer 80 is disposed on the anti-reflection layer 70, and the second opening O2 is formed in both the anti-reflection layer 70 and the conductive layer 80. In some other embodiments, the conductive layer 80 is disposed between the anti-reflection layer 70 and the filter structure 30 or between the filter structure 30 and the passivation layer 50 (not shown). In some embodiments, the conductive layer 80 can be transparent for the light in the target wavelength range (for example, having a transmittance larger than 90%), and the conductive layer 80 may have a thickness in a range of 20 nm to 300 nm to keep the transmittance as high as possible. In the horizontal direction (corresponding to X-axis), the conductive layer 80 may have a width equal to or smaller than the first width W1 of the absorption layer 23.

In some embodiments, the conductive layer 80 include a semiconductor or a metal oxide, such as gallium arsenide (GaAs), indium phosphide (InP), silicon carbide (SiC), gallium phosphide (GaP), zinc oxide (ZnO), gallium nitride (GaN), aluminum nitride (AlN), germanium (Ge), silicon (Si), indium tin oxide (ITO), indium oxide (InO), tin oxide (SnO), cadmium tin oxide (CTO), antimony tin oxide (ATO), aluminum zinc oxide (AZO), zinc tin oxide (ZTO), gallium zinc oxide (GZO), indium tungsten oxide (IWO), zinc oxide (ZnO), indium zinc oxide (IZO), or titanium oxynitride (TiON).

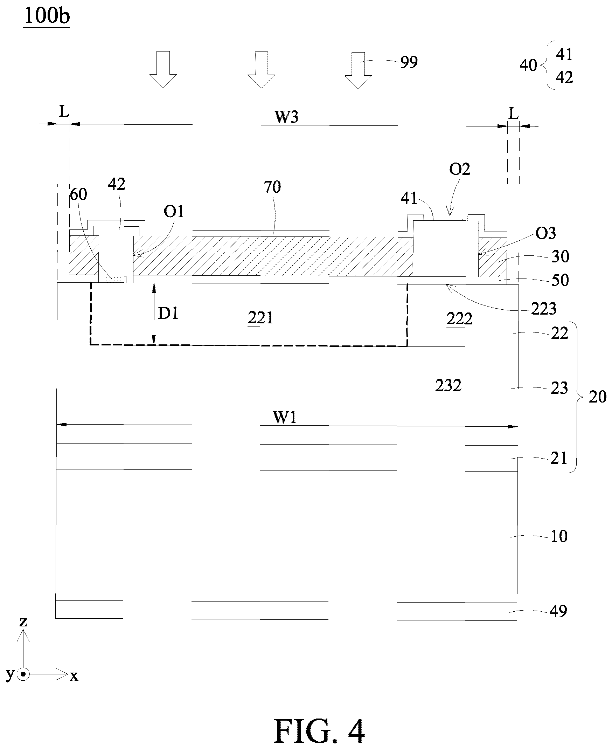

Refer to FIG. 4, FIG. 4 shows a schematic sectional view of a light detecting device 100b according to some other embodiments of the present disclosure. The light detecting device 100b has a structure similar to the light detecting device 100a. In the present embodiment, the third width W3 of the filter structure 30 may be smaller than the first width W1 of the absorption layer 23. Specifically, in some embodiments, the passivation layer 50, the filter structure 30 and/or the anti-reflective layer 70 may optionally not be disposed on a periphery area of the second semiconductor layer 22, so that the yield of a dicing process of the light detecting device 100b can be improved. When the light detecting device 100b includes the conductive layer 80 (not shown) described in previous embodiments, the conductive layer 80 also may not be disposed on the periphery area of the second semiconductor layer 22, and the width of the conductive layer 80 may be equal to the third width W3 of the filter structure 30 and smaller than the first width W1 of the absorption layer 23. The periphery area of the semiconductor stack 20 may be defined as a region within a length L from the edge of the second semiconductor layer 22, and the length L may be in a range of 10 µm to 30 µm. In the present embodiment, the second dopant does not diffuse into the absorption layer 23, so the absorption layer 23 in the present embodiment does not include the third doping region 231.

As shown in FIG. 4, a third opening O3 may optionally be formed in the filter structure 30, and the third opening O3 may have a depth equal to or smaller than the thickness of the filter structure 30. In some embodiments, the third opening O3 is optionally formed in the passivation layer 50 but does not penetrate through the passivation layer 50. In some embodiments, the pad portion 41 is disposed within the third opening O3 and is located on the passivation layer 50 without contacting the second semiconductor layer 22. Thus, the thickness of the light detecting device 100b can further be reduced compared to the light detecting device 100a. The positions, relative relationships, and material compositions of other layers or structures as well as structural variations in the light detecting device 100b have been described in detail in previous embodiments and are not repeatedly described herein.

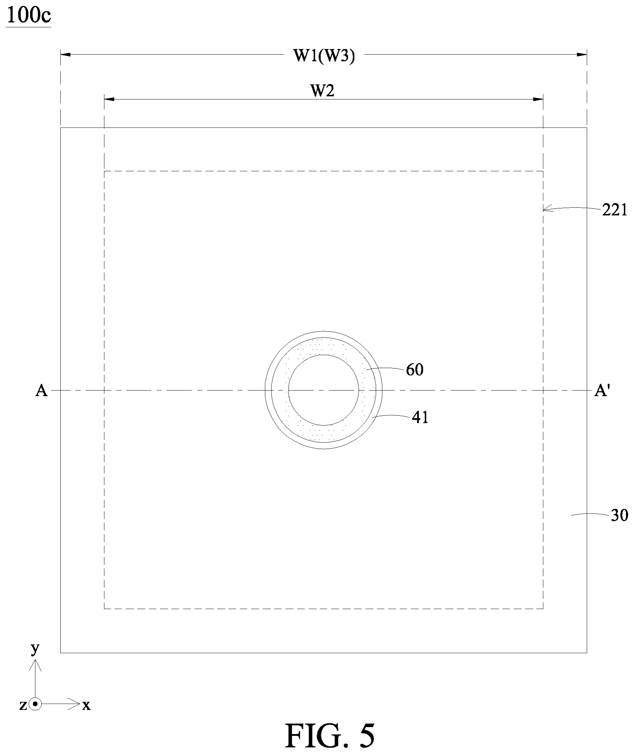

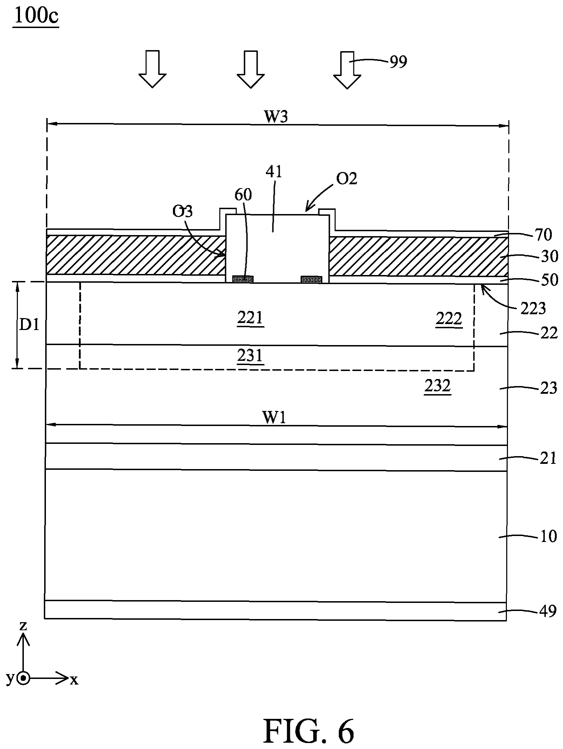

Refer to FIG. 5 and FIG. 6, FIG. 5 shows a schematic top perspective view of a light detecting device 100c according to some embodiments of the present disclosure, and FIG. 6 shows a schematic sectional view of the light detecting device 100c along a section line A-A' in FIG. 5. The light detecting device 100c has a structure similar to the light detecting device 100a. In the present embodiment, the first electrode structure 40 does not include the extending portion 42, and the pad portion 41 is disposed on the first doping region 221. Herein, the area of the first surface 223 blocked by the first electrode structure 40 can be reduced and a strength of the electrical signal outputted by the light detecting device 100c can be improved. As shown in FIG. 5 and FIG. 6, the pad portion 41 is disposed at a position corresponding to a geometric center of the first doping region 221 to optimize the transmission of electrons or holes within the light detecting device 100c.In some embodiments, the first contact structure 60 is disposed below the pad portion 41, and may be patterned to have a shape corresponding to the edge of the pad portion 41 to improve current distribution within the light detecting device 100c. The positions, relative relationships, and material compositions of other layers or structures as well as structural variations in the light detecting device 100c have been described in detail in previous embodiments and are not repeatedly described herein.

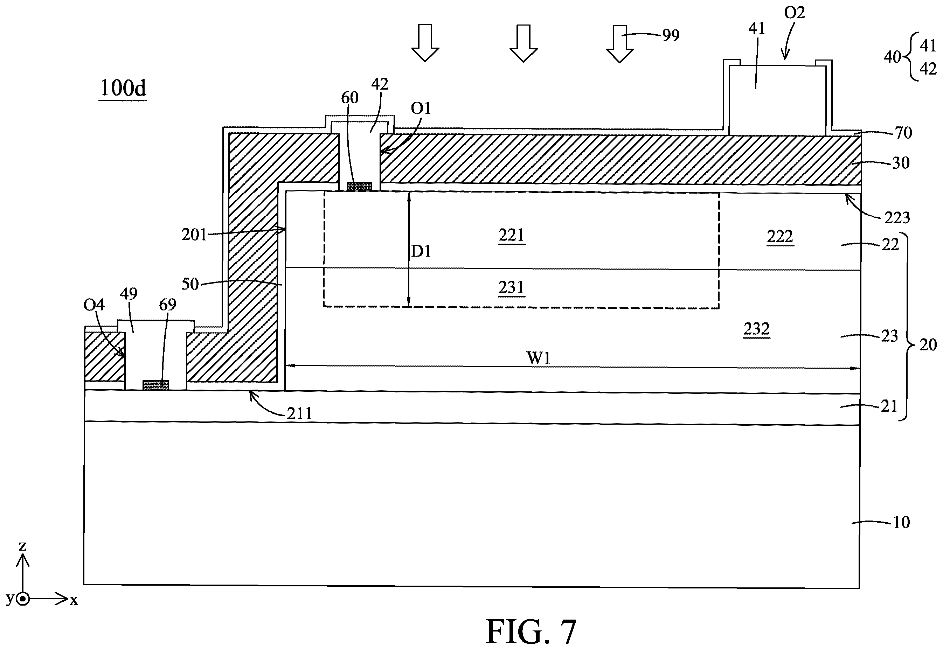

Refer to FIG. 7, FIG. 7 shows a schematic sectional view of a light detecting device 100d according to still other embodiments of the present disclosure. The light detecting device 100d has a structure similar to the light detecting device 100a. In the present embodiment, the first semiconductor layer 21 and the base 10 of the light detecting device 100d have a fourth width W4 larger than the first width W1 of the absorption layer 23. Specifically, the first semiconductor layer 21 has a second surface 211 which is not covered by the absorption layer 23 and the second semiconductor layer 22, and the second electrode structure 49 is disposed on the second surface 211 and directly contact the first semiconductor layer 21. Therefore, the first electrode structure 40 and the second electrode structure 49 are located at the same side of the first semiconductor layer 21 or the base 10 to form a horizontal type light detecting device. In some embodiments, the light detecting device 100d may optionally include a second contact structure 69 located between the second electrode structure 49 and the first semiconductor layer 21 to reduce the resistance formed therebetween. In some embodiments, the second contact structure 69 may have a material and a thickness same as those of the first semiconductor layer 21, and the second contact structure 69 can have a fifth dopant to have a conductivity type same as that of the first semiconductor layer 21.

As shown in FIG. 7, the semiconductor stack 20 includes a side wall 201 connecting the first surface 223 and the second surface 211. In addition to covering the first surface 223, the passivation layer 50 also covers the side wall 201 and the second surface 211 to protect the semiconductor stack 20. In some embodiments, the filter structure 30 and/or the anti-reflection layer 70 also extend to cover the side wall 201 and the second surface 211 to prevent the light outside the target wavelength range from entering the absorption layer 23 and/or the second semiconductor layer 22 from the side wall 201 to induce the noise. In some embodiments, a fourth opening O4 may be formed in the passivation layer 50, the filter structure 30 and/or the anti-reflection layer 70 to expose the second electrode structure 49, so that the second electrode structure 49 can connect to the external power through the fourth opening O4. The positions, relative relationships, and material compositions of other layers or structures as well as structural variations in the light detecting device 100d have been described in detail in previous embodiments and are not repeatedly described herein.

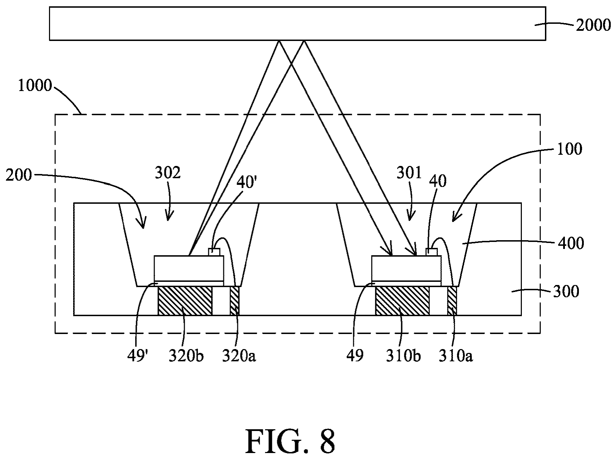

Refer to FIG. 8, FIG. 8 shows a schematic sectional view of a light detecting module 1000 according to some embodiments of the present disclosure. The light detecting module 1000 includes a carrier 300, a light emitting device 200, the light detecting device 100 and an encapsulation structure 400. The carrier 300 includes a first trench 301 and a second trench 302. The light detecting device 100 and the light emitting device 200 are located in the first trench 301 and the second trench 302 respectively. The encapsulation structure 400 covers the light detecting device 100 and the light emitting device 200 which are in the first trench 301 and the second trench 302. The light detecting device 100 may include the light detecting devices 100a, 100b, 100c or 100d described in the previous embodiments. In some embodiments, the light emitting device 200 includes a third electrode structure 40' and a fourth electrode structure 49', and further includes an active layer capable of emitting light with a specific wavelength. For example, the light emitting device 200 can emit infrared light with a peak wavelength in a range of 800 nm to 2000 nm, such as 810 nm, 850 nm, 910 nm, 940 nm, 1050 nm, 1070 nm, 1100 nm, 1200 nm, 1300 nm, 1400 nm, 1500 nm, 1600 nm, 1700 nm, 1800 nm or 1900 nm. In some embodiments, the wavelength of the light emitted by the light emitting device 200 is within the target wavelength range of the light detecting device 100. In some embodiments, the light emitting device 200 and the light detecting device 100 may include the same material. For example, the light emitting device 200 and the light detecting device 100 both include materials of AlInGaAs, AlGaInP, InGaAs and/or InGaAsP.

In some embodiments, the carrier 300 includes first circuit structures 310a, 310b electrically connected to the first electrode structure 40 and the second electrode structure 49 of the light detecting device 100 respectively to receive the electrical signal generated by the light detecting device 100. In some embodiments, the carrier 300 includes further second circuit structures 320a, 320b electrically connected to the third electrode structure 40' and the fourth electrode structure 49' of the light emitting device 200 respectively to drive the light emitting device 200 to emit the light. The light detecting module 1000 may be incorporated in a mobile device, and may be used as a proximity sensor, a structured light scanner or a biosensor.

In some embodiments, when the mobile device including the light detecting module 1000 approaches an object 2000, a light 90 with the specific wavelength emitted by the light emitting device 200 is reflected by the object 2000 to the light detecting device 100, and the electrical signal is generated by the light detecting device 100 for sensing the existence of the object 2000 and triggering an action, e.g. turning on or off the screen of the mobile device accordingly. In some embodiments, the carrier 300 may be a package submount or a printed circuit board (PCB). In some embodiments, the third and fourth electrode structures 40', 49', the first circuit structures 310a, 310b and the second circuit structures 320a, 320b include a single-layer or multi-layer structure and include nickel (Ni), titanium (Ti), platinum (Pt), palladium (Pd), silver (Ag), gold (Au), aluminum (Al) or copper (Cu). In some embodiments, the encapsulation structure 400 may include an organic polymer or inorganic dielectric material, for example, epoxy or silicone.

**In** conclusion, according to any embodiment in the present disclosure, a light detecting device and a light detecting module including thereof are provided. Specifically, the light detecting device and the light detecting module shown in the present disclosure can reduce noise to improve their signal-to-noise ratio (SNR). The light detecting device and the light detecting module shown in the present disclosure can be applied to products in fields of night vision, ranging, biosensing and communication, such as night vision cameras, infrared rangefinders, heart rate sensors, wearable blood oxygen monitoring devices, optical communication modules, LiDAR systems for autonomous vehicles, security surveillance systems, and optical diagnostic instruments for medical use.

Although the present disclosure has been described in considerable detail with reference to certain embodiments thereof, the disclosure is not for limiting the scope of the invention. Persons having ordinary skill in the art may make various modifications and changes without departing from the scope a of the disclosure. Therefore, the scope of protection of the present disclosure shall be defined by the appended claims.

## Claims

1. A light detecting device (100), comprising:
a first semiconductor layer (21);
an absorption layer (23) located on the first semiconductor layer (21);
a second semiconductor layer (22) located on the absorption layer (23);
a filter structure (30) located on the second semiconductor layer (22), wherein the filter structure (21) comprises a plurality of first layers (31) and a plurality of second layers (32) which are alternately stacked,
an opening (O1) formed in the filter structure (30); and
an electrode structure (40) disposed on the filter structure (30) and connecting the second semiconductor layer (22) through the opening (O1);
wherein the plurality of the first layers (31) comprises an uppermost first layer (31n) with a first refractive index (n1i) and one of the plurality of second layers (32) has a second refractive index (n2i) larger than the first refractive index;
the uppermost first layer (31n) located between the electrode structure (40) and the plurality of second layers (32), and the uppermost first layer (31n) directly contacts the electrode structure (40).

2. The light detecting device according to claim 1, wherein the second semiconductor layer (22) has a third refractive index (n3i) larger than the first refractive index (n1i).

3. The light detecting device according to claim 1 or 2, wherein the second semiconductor layer (22) has a third refractive index (n3i) equal to or smaller than the second refractive index (n2i).

4. The light detecting device according to any one of the preceding claims, wherein the plurality of first layers (31) comprises a lowermost first layer (311), and the plurality of second layers (32) are located between the lowermost first layer (311) and the uppermost first layer (31n).

5. The light detecting device according to any one of the preceding claims, wherein a sum of thicknesses of the plurality of first layers (31) is larger than a sum of thicknesses of the plurality of second layers (32).

6. The light detecting device according to any one of the preceding claims, further comprising a contact structure (60) located between the second semiconductor layer (22) and the electrode structure (40) without contacting the filter structure (30).

7. The light detecting device according to claim 6, wherein the contact structure (60) is disposed in the opening (O1).

8. The light detecting device according to any one of the preceding claims, wherein the electrode structure (40) comprises a pad portion (41) disposed on the uppermost first layer (31n) and an extending portion (42) connecting the pad portion (41) and the second semiconductor layer (22).

9. The light detecting device according to claim 8, wherein the second semiconductor layer (22) comprises a first doping region (221) and a second doping region (222) surrounding the first doping region (221), and the pad portion (41) does not overlap with the first doping region (221) in a vertical direction.

10. The light detecting device according to claim 9, wherein the opening (O1) overlaps with the first doping region (221) in the vertical direction, and the extending portion (42) connects the first doping region (221) through the opening (O1).

11. The light detecting device according to any one of the preceding claims, further comprising a passivation layer (50) located between the filter structure (30) and the second semiconductor layer (22).

12. The light detecting device according to claim 11, further comprising a conductive layer (80) disposed on the passivation layer (50) without contacting the second semiconductor layer (22).

13. The light detecting device according to any one of the preceding claims, wherein the second semiconductor layer (22) has a thickness larger than that of the filter structure (30).

14. The light detecting device according to any one of the preceding claims, wherein the absorption layer (22) has a first width, and the filter structure (30) has a second width equal to the first width.

15. A light detecting module (1000), comprising:
a carrier (300);
a light emitting device (200) located on the carrier (300) and emitting a light;
a light detecting device (100) of any one of the preceding claims located on the carrier (300) and detecting the light; and
an encapsulation structure (400) covering the light emitting device (200) and the light detecting device (100).
